# EUROPEAN PATENT APPLICATION

(11) **EP 4 521 902 A1**
(43) Date of publication of application: **12.03.2025**
(21) Application number: 24198597.7
(22) Date of filing: 05.09.2024
(51) Int. Cl.: H10K 59/38, F21V 33/00

(54) **OLED DEVICE GENERATING LIGHT AND ACTIVE SIGNALING SYSTEM OF A WORKER USING SAID DEVICE**

(30) Priority: 07.09.2023 IT 202300018360
(71) Applicant: Klopman International S.r.l., 03100 Frosinone (FR) (IT); Consiglio Nazionale Delle Ricerche - CNR, 00185 Roma (IT)
(72) Inventor: ANDRETTA, Antonio, 03100 Frosinone (IT); GIANNANTONIO, Roberto, 03100 Frosinone (IT); GRECO, Daniele, 03100 Frosione (IT); MARIANO, Fabrizio, 03100 Frosione (IT); MAIORANO Vincenzo, Rome, 00185 (IT); GIGLI Giuseppe, Rome, 00185 (IT); PRONTERA Carmela Tania, Rome, 00185 (IT); PUGLIESE Marco, Rome, 00185 (IT)
(74) Representative: Vatti, Francesco Paolo

(57) **Abstract**

Active signalling device and system for a person, based on a light-generating OLED, said device being formed by an OLED component cooperating with a luminescent fabric, wherein the cooperation is allowed by a transparent planarising layer and the OLED component is formed by, in the following order:
• one or more transparent anti-permeant layers;
• a first semi-transparent or transparent electrode;
• one or more transparent organic material layers;
• a single emitting layer;
• one or more transparent organic material layers;
• a second semi-transparent or transparent electrode;
• one or more transparent impermeable layers;
and wherein, during operation, the luminescent fabric is capable of down-converting the light emitted by the single emitting layer, wherein the light emitted by the single emitting layer and the down-converted light, being overlapped upon one another, generate an overlapped light, of secondary colour, preferably white.

## Description

### TECHNICAL FIELD OF THE INVENTION

The present invention, in general, relates to devices based on OLED (organic light-emitting diode) technology. In particular, a first aspect of the present invention relates to an OLED device capable of generating light of a desired colour (monochromatic OLED), or preferably white light.

A second aspect of the present invention is an active signalling system for an operator who uses such an OLED device on fabric.

A third aspect of the present invention also relates to a system for signalling the presence of a person, even at a distance. More specifically, an OLED device is constructed directly on items of clothing, including workwear.

### PRIOR ART

Technical clothing is a key element for numerous categories of workers (for example, workers in the construction, road, mining, etc. industries). Technical fabrics, for these categories of workers, must have some additional properties to those of traditional fabrics, so as to make the garments suitable for use in the workplace; examples include high mechanical strength (e.g. against cuts and perforations) and fire resistance.

Although technical fabrics (and consequently technical clothing) have historically been used to provide protection to workers in the event of accidents (e.g. chemical, electrical, mechanical, etc. protection), in recent years additional features have been provided, with preventive functions.

An example of how prevention can be implemented is through the use of devices capable of enhancing an operator's visibility in the workplace. Such prevention systems can be passive or active and support the worker by making him/her visible even in poorly lit environments.

Among the passive elements, reflector components are among the most common, but have the disadvantage of improving the visibility of a user only when illuminated by other sources. Fabrics containing reflector components provide a passive prevention of accidents, not completely nor under every circumstance solving the problem of signalling the presence of a worker.

Some modern technical clothing provide for active prevention, achieved by installing light sources on them. Light sources suitable for this purpose must have certain characteristics: high reliability, small size, sufficient brightness and high flexibility.

Examples of clothing using active and passive signalling are described in WO 2015/148769. In that description, a reflective fabric is used to increase the light from a light source (e.g. light-emitting diodes, LEDs or OLEDs).

The use of OLEDs, owed to their demonstrated greater flexibility compared with LEDs, is preferable, especially in a field such as the manufacture of professional garments, where greater flexibility equates to easier movement for a worker, which is also important in the prevention of accidents.

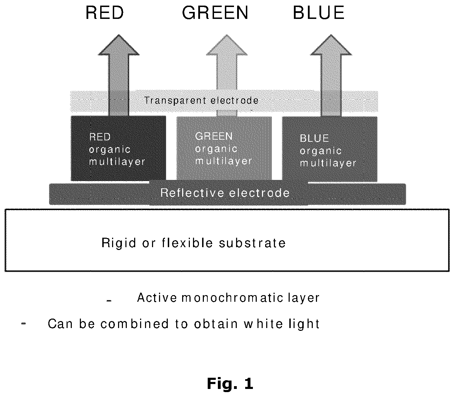

In general, in order to be able to integrate an OLED device on a non-transparent substrate (such as a technical fabric), a *top emitting* architecture must be used, as shown in Figure 1. Such OLED architectures provide for the application of a reflective electrode onto a smooth, rigid or flexible substrate. Organic layers and a transparent upper electrode are then deposited on the reflective electrode, allowing the light generated inside the device to escape. This light is in general monochromatic when the emissive layer is formed by a single material. However, for white light generation, it is necessary to combine together the emissions of different colour sources. In general, red, green and blue light emitting materials are used, assembled in different configurations, as shown in Figure 1. In addition, the monochromatic light sources can be further combined with one another to produce additional colours (e.g. secondary colours).

The manipulation of primary colour sources to obtain a secondary or white colour light is a known phenomenon: solutions associated with the present invention are WO2005/005 571 and US 2016/0 043 288.

However, the use of multiple coloured sources has the disadvantage of complicating the manufacturing process of the device. Thus, alternative solutions provide for the use of a monochromatic blue source combined with materials capable of down-converting (absorbing high energy radiation and emitting it at lower energy) this light into other colours, in order to obtain overall a white light.

In this regard, some patents describe simplified structures using a single emissive material, then exploiting the ability of some fluorophores to absorb part of the radiation and re-emit it with a different colour.

WO 2005/005 571 describes an electroluminescent element comprising an organic or inorganic material that emits blue light and at least one fluorescent material, which absorbs that blue light, in turn re-emitting a fluorescence in the region of visible light at lower energy. The organic or inorganic material includes a diketopyrrolopyrrole. The fluorescent material, in WO 2005/005 571, is in the form of powder.

US 2016/0 043 288 describes a system formed by a LED module, emitting blue light, and a resin to which a fluorescent powder has been added, capable of converting part of the blue light emitted by the LED, generating white light. Systems such as the one just described are based on LED technology, and therefore on rigid and bulky systems. These characteristics, with a view to integration on technical fabrics, would have a negative impact on the comfort of the item of clothing.

In general, therefore, the need to simplify the manufacturing processes of an electroluminescent system integrated on technical clothing fabrics is a topic of high technological interest; as the complexity of a system increases, there is a greater chance of introducing defects during the production process. As a result, in addition to higher manufacturing costs, the probability of device malfunction can also increase.

### PROBLEM AND SOLUTION

In order, therefore, to achieve a stable and efficient active prevention system, it is therefore useful to aim for simplified structures, which have the dual advantage of improving the reliability of the system and reducing production costs.

Although light signalling can also be achieved by monochromatic sources, white light is preferable as regards active signalling, since in poorly lit environments (such as roadways under poorly lit conditions), or in environments with large amounts of dust (building sites, mines), or even in environments with large amounts of smoke, white light is easily detectable by the human eye. Furthermore, it does not alter the colour perception of objects and people in the immediate vicinity.

On the basis of the above considerations, it is therefore necessary to develop a system for the active signalling of the presence of a worker, based on flexible and conformable OLED technology, generating visible and/or white light and having a structure as simple as possible, so that it can be installed or integrated or directly manufactured, for example, on technical clothing fabrics, so as to simultaneously ensure simplicity of production processes, high stability and low production costs. To achieve this aim, the OLED device generating light of a determined wavelength (colour) is characterised in that a device based on monochromatic emission OLED technology is combined with luminescent fabric. The latter must be capable of absorbing part of the light emitted by the OLED and re-emitting it with a different colour (at a greater wavelength). The sum of the two colours, that emitted by the OLED and that re-emitted by the fabric, generate white light or secondary light. A first possible solution to achieve this objective provides for the use of an electroluminescent system, formed by:
- A luminescent fabric, capable of absorbing the light emitted by the OLED device and of re-emitting it at lower energies, and therefore with a different colour (down-conversion), such that the sum of the emitted colours (by the fabric and the OLED) yields a white light or secondary light;
- A transparent planarising layer, to make the fabric suitable for interfacing with the OLED device layers;
- An anti-permeant barrier (made using Barix or ALD technology) to limit the permeation of water vapour and oxygen, which at the same time is the flexible and transparent substrate for the OLED device;
- An electroluminescent device based on highly transparent OLED technology, which in turn includes:
   - a first semi-transparent or transparent lower electrode;
   - a hole injection layer (HIL);
   - a hole transport layer (HTL);
   - an active electroluminescent layer (EML) emitting monochromatic light;
   - an electron transport layer (ETL);
   - a second semi-transparent or transparent upper electrode;
- An upper transparent anti-permeant barrier;
- A protective transparent polymeric layer.

A second possibility provides for the use of an electroluminescent system, formed by:
- A luminescent fabric, capable of absorbing the light emitted by the OLED device and of re-emitting it at lower energies, and therefore with a different colour (down-conversion), such that the sum of the emitted colours (by the fabric and the OLED) yields a white light or secondary light;
- A transparent adhesive layer, to irreversibly connect the fabric to the OLED device;
- An anti-permeant barrier to limit the permeation of water vapour and oxygen, which at the same time is the flexible and transparent substrate for the OLED device;
- A transparent electroluminescent device based on OLED technology, which in turn includes:
   - a first semi-transparent or transparent lower electrode;
   - a hole injection layer (HIL);
   - a hole transport layer (HTL);
   - an active electroluminescent layer (EML) emitting monochromatic light;
   - an electron transport layer (ETL);
   - a second semi-transparent or transparent upper electrode;
- An upper transparent anti-permeant barrier;
- A protective transparent polymeric layer.

The dependent claims describe preferred characteristics of the invention.

### BRIEF DESCRIPTION OF THE DRAWINGS

Other features and advantages of the invention will become clearer from the following detailed description of a preferred embodiment, given purely by way of example and in a non-limiting manner, and illustrated in the appended drawings in which:
- Figure 1 illustrates *top emission* white OLED systems, commonly used in the case of non-transparent substrates and the arrangement of the essential elements forming said OLED systems of the prior art;
- Figure 2 illustrates the OLED system for the production of white light according to the present invention;
- Figure 3 is an absorption/emission spectrum of the absorbed light and the light produced by the system of the present invention; and

- Figure 4 is an emission spectrum of a blue emitting OLED that highlights the differences between a non-luminescent fabric and a luminescent fabric;

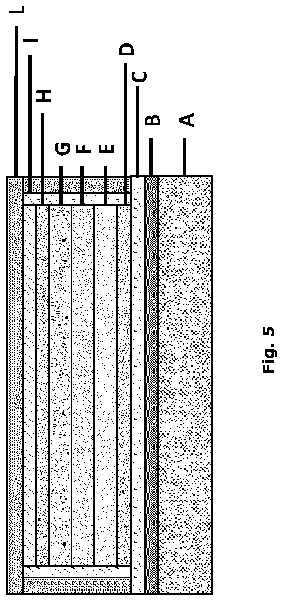

- Figure 5 schematically shows an OLED integrated directly on fabric; A is a fabric; B is a planarising layer (UV or thermoset epoxy resins, polyurethanes, polyacrylates, siloxanes, silicones, which can be deposited using processes including solution deposition, dripping deposition, blading, slot casting, screen printing, inkjet printing); C is an anti-permeant barrier, preferably made using Barix technology - alternating Si₃N₄/polyacrylate layers - or ALD (Atomic Layer Deposition) - single compact layer of Si₃N₄ - both the Barix layer and the ALD layer requiring deposition processes carried out under high vacuum and taking place batchwise; D is a transparent electrode, formed by formulations of conducting polymers, such as PEDOT:PSS deposited by solution processes, or inorganic materials such as ITO deposited by sputtering; E is a hole transport layer (HTL); F is an active layer; G is an electron transport layer (ETL); H is a transparent electrode, formed by formulations of conductive polymers, such as PEDOT:PSS deposited by solution processes, or inorganic materials such as ITO deposited by sputtering, or metal-oxide multistacks such as silver/tungsten oxide which multistacks can be deposited by vacuum thermal evaporation; I is an anti-permeant barrier similar to C; and L is a protective layer, produced as a coating of transparent polymeric material, used primarily to protect against scratches, but also capable of withstanding washing in the event of soiling; and

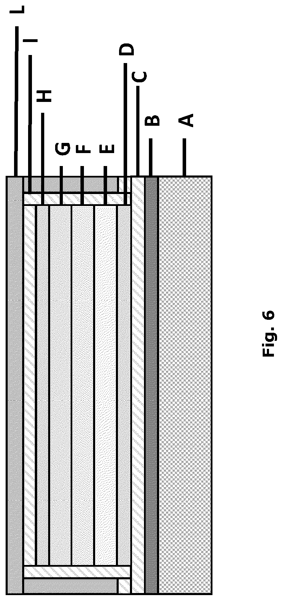

- Figure 6 shows an OLED indirectly integrated on fabric: A indicates a fabric; B an adhesive layer (UV or thermoset epoxy resins or industrial liquid adhesives, which can be deposited using techniques including solution deposition, dripping deposition, blading, slot casting, screen printing, and inkjet printing, or industrial film adhesives, which can be deposited using lamination or other compatible techniques); C is an anti-permeant barrier, made in this example with 3M self-standing barrier film technology, the upper barrier film being thermally bonded to the lower barrier film; D is a transparent electrode, produced as a formulation of conductive polymers, such as PEDOT:PSS, and deposited using solution deposition processes, or inorganic materials such as ITO deposited by sputtering; E is a hole transport layer (HTL); F is an active layer; G is an electron transport layer (ETL); H is a transparent electrode, produced as a formulation of conductive polymers, such as PEDOT:PSS deposited using solution deposition processes, or inorganic materials such as ITO deposited by sputtering, or metal-oxide multistacks such as silver/tungsten oxide which multistacks can be deposited by vacuum thermal evaporation; I is another anti-permeant barrier similar to C; and L is a protective layer, produced as a coating of transparent polymeric material and used primarily to protect against scratches, but also must be capable of withstanding washing in the event of soiling.

### DETAILED DESCRIPTION OF THE PREFERRED EMBODIMENT

The Applicant, looking for the ideal solution to the abovementioned problems, has discovered an OLED device capable of generating (preferably white) light, the application of which can vary from the active signalling of a user to, for example, applications related to the field of shipments (for example, an OLED device according to the present invention can be installed on a package, in order to highlight any fragility or possible biological/chemical risk of the contents, to alert shipping personnel to exercise caution) or for advertising (for example, supplying lightweight and highly flexible installations for indoor and/or outdoor use).

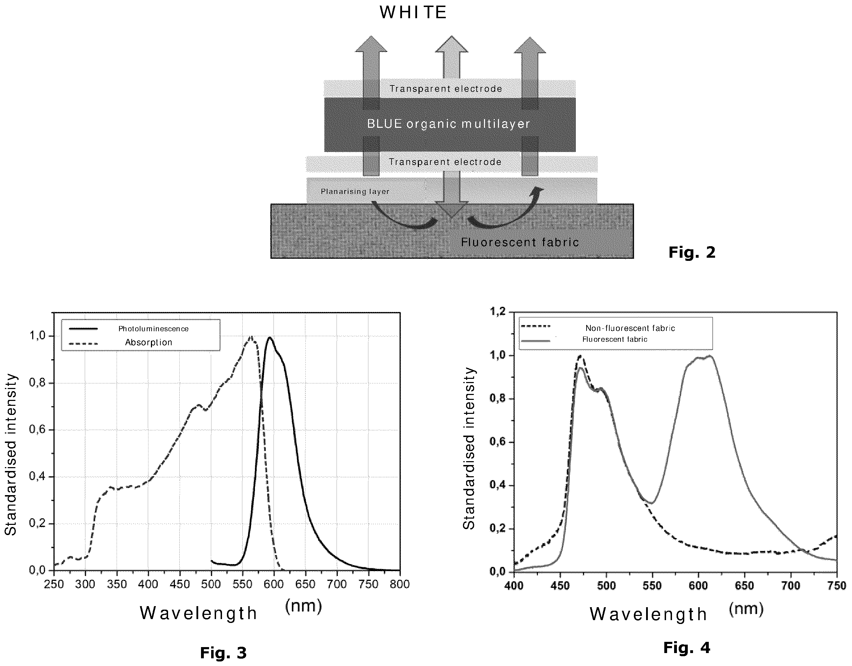

An OLED device according to the present invention is shown schematically in Figure 2. Essentially, the device/system according to the present invention manipulates light (preferably blue light) provided by an OLED component, so as to obtain light of a desired colour (preferably white) in an extremely simple manner. The manipulation of the light produced by an OLED component takes place through a single manipulation means, i.e. a luminescent fabric; hence, also being of reduced size and greater constructional simplicity compared with the prior art.

The device is essentially formed by an OLED component, which is formed by two semi-transparent or transparent electrodes, and an organic multilayer (which includes an emissive layer) and cooperates, through a planarising layer or alternatively through an adhesive layer (both transparent), with a luminescent fabric, which is to be considered a constituent part of the device/system according to the present invention. Cooperation between the OLED component and the luminescent fabric is made functional through the planarising or adhesive layer, and is maintained through integration or installation.

The OLED component of the present invention is protected from water vapour, oxygen and dust by anti-permeant layers, which will be discussed in detail later.

As anticipated in the preamble, the light emitted by the emitting layer has a wavelength in the visible region, preferably between 425 nm and 525 nm, i.e. in a range which varies from blue through to cyan/green. The luminescent fabric must be capable of absorbing light at these wavelengths (and re-emitting it in a different colour), such that the device/system according to the present invention is capable of generating secondary or white overlapped light.

From a chemical perspective, the emitting layer of the OLED component can be formed by polymers or small electroluminescent molecules. It is understood that the two electrodes in the component play the role of cathode and anode during operation. Without limitations, the two electrodes can be:
- thin films of Indium Tin Oxide (ITO);
- thin films of conductive polymers, such as poly(3,4-ethylenedioxythiophene) poly(styrene sulfonate) polymers;
- thin films of metals, for example chosen from aluminium or silver;
- metal/oxide or oxide/metal/oxide multilayer, e.g. a multilayer of Ag/WOs.

Particularly preferred embodiments of the OLED component contain a combination of two different electrodes, of the types listed above.

Particularly preferred is the use of ITO films as lower electrode and Ag/WOs multilayer as upper electrode. The requirement to be met for the use of a material as electrode in the OLED system of the present invention is semi-transparency or transparency (a transmittance higher than 30%, more preferably a transmittance higher than 60%).

The planarising layer illustrated in Figure 2 can be defined as a layer that minimises the surface roughness of the underlying fabric. In particular, the planarising layer corrects the surface morphology of a fabric, which as is known has gaps between warp and weft, exposed fibres, local inhomogeneities, etc. The planarising layer is hence applied to a rough and inhomogeneous surface (that of the fabrics), with the aim of planarising the surface (reducing the roughness to a few nm) on which the layers forming an OLED device will then be deposited. The use of a planarising layer is necessary for the correct operation of the system according to the invention, since OLED technology is intrinsically incompatible with applications on rough or irregular surfaces, such as those of fabrics, including technical fabrics.

If the surface with which an OLED component cooperates is coarse or rough, being an OLED component formed by extremely thin stacked layers (such as electrodes, emitting layer etc.), the surface roughness is transferred to each layer, adversely affecting the performance of the component or even compromising operation.

In some embodiments, cooperation between the OLED component and the luminescent fabric is established by manufacturing the OLED component directly on said luminescent fabric, including a planarising layer, deposited by techniques compatible with the processing of fabrics, for example dip coating, inkjet printing, lamination, roller transfer, doctor blading, spatula coating, etc.

In yet another embodiments, cooperation between the OLED component and the luminescent fabric is established by installing the OLED component on the fabric. Installation can be by bonding with specific transparent adhesive films deposited by lamination, printing or other compatible techniques; or by applying buttons or other means available to the person skilled in the art.

The surface with which the component cooperates, as anticipated, is indeed a luminescent fabric, preferably a luminescent technical fabric, made either of natural fibres or of synthetic fibres or of a blend of natural and synthetic fibres. Preferably, the fabric is a blend of cotton and polyester. Preferably, the fabric is a 50/50 blend of cotton and polyester.

In addition, one or more transparent impermeable layers must be added to protect the component from external agents, mainly from oxygen and moisture, in order to prevent the component from being damaged, reducing its performance or interrupting its operation. Examples of anti-permeant layers are commercially available from Vitex (Barix product) and 3M (FTB3-50 and similar).

The one or more impermeable layers are preferably closed by heat or by resins, sealing the edges thereof and providing a pouch-type coating, conforming to the component, or even sealed by the application of specific resins distributed over the entire surface of the device, on which the impermeable layer is then laminated.

An additional method for encapsulating the OLED device provides for the deposition of an anti-permeant multilayer directly on the surface of the device, by means of *thin film encapsulation* (TFE) techniques.

The OLED device can then interact with the luminescent fabric to modulate the colour of the light emitted overall. In fact, the inventors have discovered that, in order to generate white or secondary light, it is necessary to place an electroluminescent device in contact with a luminescent fabric. In practice, an OLED system of the type described previously is particularly preferred, in which the light emitted by the single emitting layer has a wavelength within the visible range (between 380 nm and 780 nm), preferably between 425 nm and 525 nm, in which the luminescent fabric down-converts part of the light emitted by the single layer into a light with a longer wavelength.

In other words, the luminescent fabric is capable of converting (changing the colour) part of the light emitted by the single emissive layer; the light emitted by the single emissive layer together with the converted light, overlapping on one another, generate a combined light, preferably white.

In operation, once the OLED component is activated, the light generated (i.e. preferably blue light) starts to propagate in all directions. Since the two electrodes and the planarising layer are transparent or semi-transparent, the light begins to spread to both the side on which it is cooperating with the fabric and to the outside. The light scattered towards the luminescent fabric is absorbed and undergoes a conversion process (down-conversion) - a process in which high energy light (shorter wavelength) is absorbed by a luminescent material and then re-emitted at lower energy light (longer wavelength). In particular, in order to obtain white light, the OLED source must emit blue light, and must be partially absorbed by a luminescent fabric that re-emits it in orange/red colour, such that the overlapping between blue and orange/red gives rise to an overall white light.

Of course, this may also be the case, if necessary, for other colours by a similar process, starting from a light of a colour other than blue and/or using a fabric with luminescence of another colour.

Examples of emission spectra of active signalling systems are illustrated in Figure 4 for the case of an OLED component of the type described above installed on a luminescent and non-luminescent fabric. As noted, the non-luminescent fabric does not allow light conversion and a simple emission of light takes place, peaked in the blue region (470 nm), whereas in the case of the luminescent fabric (in the red region), the emitted light comprises a good part of the wavelengths in the visible range (450 nm to 750 nm), with a peak in the blue region (470 nm) and one in the red region (610 nm), therefore resulting in white.

Examples of commercial fabrics that can be used in the present invention are the Applicant's Luminex models, which are either orange or red or orange/red in colour. Surprisingly, the active signalling system according to the invention also functions on luminescent fabrics on which finishes (of the kind that make the fabric impermeable) have been applied, as in the case of the Luminex C50 model, also of the Applicant.

The active signalling system component can be obtained by prefabricating the OLED component and, once sealed with impermeable layers, establishing co-operation with a fluorescent fabric by means that are known per se, such as by adhesives, glues, or by using snap fasteners. Preferably, the OLED component should be placed between two impermeable layers, which must then be thermally bonded or bonded together, so as to protect the component from environmental moisture.

It is also possible to integrate the OLED component on a luminescent fabric or on technical clothing with luminescent fabric. "Integrate" is understood to mean that it is impossible to remove the OLED component from the integrated substrate without compromising the operation of the device/system.

The OLED or active signalling system may also be constructed by directly applying, in the following order, to a luminescent fabric: a planarising layer, an impermeable layer, an OLED component of the type described above and a second impermeable layer. It is understood that in the abovementioned construction methods, the sealing of the OLED component is carried out by hot-melting means or by bonding of impermeable layers.

The impermeable layers can be sealed along the perimeter of the component, in that case ensuring a pouch-type coating, or sealed by the application of specific resins distributed over the entire surface of the device, on which the impermeable layer is subsequently laminated, or by the deposition of an anti-permeant multilayer directly on the surface of the device, using *thin film encapsulation* (TFE) techniques.

As can be understood, the OLED device and the active signalling system of the present invention do not require reflecting means (such as refracting means or mirrors) to be able to enhance the light emitted and, moreover, it is simple from a construction perspective and exhibits high mechanical flexibility. The impermeable layers, on the other hand, protect the system from malfunctions due to moisture, dust, oxygen and other atmospheric agents, ensuring longevity of the system and enabling it to even be used outdoors.

The active signalling system can be installed on technical clothing, such as workers' vests, shirts, overalls, trousers, jackets and shoes.

Once the signalling system has been achieved, secondary features can be added, which will now be listed.

The active signalling system can be paired with a portable battery: simply connect the system to a DC supply, with an operating range compatible with the OLED system.

Programming can be added to the OLED-based active signalling device, in a manner that is known per se, such that it follows a particular on/off sequence, for example to signal an emergency or danger condition of the worker. Pulsed light, especially irregular pulse light, as is known, is easily perceived by the human eye.

By means of the present invention, it is possible to significantly simplify the making of a white OLED source, using a single emitter layer instead of multiple emissive layers.

It is anyway understood that the invention must not be considered to be limited to the particular arrangement illustrated above, which forms only one example embodiment thereof, but that various variants are possible, all within the capabilities of a person skilled in the art, without thereby departing from the scope of protection of said invention, which scope is defined in the claims that follow.

For example, it is also possible to apply the active signalling component to a sportsperson running in dimly lit environments.

## Claims

1. OLED device generating light of a determined wavelength (colour), **characterised in that** a device based on OLED technology with monochromatic emission is combined with a luminescent fabric.

2. Device according to Claim 1), **characterised by** an OLED device integrated with a luminescent fabric, formed by:
a luminescent fabric, capable of absorbing the light emitted by the OLED device and of re-emitting it at lower energies, and therefore with a different colour (down-conversion), such that the sum of the emitted colours (by the fabric and the OLED) yields a white light or secondary light;
a transparent planarising layer, to make the fabric suitable for interfacing with the OLED device layers;
an anti-permeant barrier (made using Barix or ALD technology) to limit the permeation of water vapour and oxygen, which at the same time is the flexible and transparent substrate for the OLED device;
an electroluminescent device based on highly transparent OLED technology, which in turn includes:
a first semi-transparent or transparent lower electrode;
a hole injection layer (HIL);
a hole transport layer (HTL);
an active electroluminescent layer (EML) emitting monochromatic light;
an electron transport layer (ETL);
a second semi-transparent or transparent upper electrode;
an upper transparent anti-permeant barrier; and
a protective transparent polymeric layer.

3. Electroluminescent device according to Claim 1), **characterised by** an OLED device integrated with a luminescent fabric, is formed by:
a luminescent fabric, capable of absorbing the light emitted by the OLED device and of re-emitting it at lower energies, and therefore with a different colour (down-conversion), such that the sum of the emitted colours (by the fabric and the OLED) yields a white light or secondary light;
a transparent adhesive layer, to irreversibly connect the fabric to the OLED device;
an anti-permeant barrier to limit the permeation of water vapour and oxygen, which at the same time is the flexible and transparent substrate for the OLED device;
a transparent electroluminescent device, based on OLED technology, which in turn includes:
a first semi-transparent or transparent lower electrode;
a hole injection layer (HIL);
a hole transport layer (HTL);
an active electroluminescent layer (EML) emitting monochromatic light;
an electron transport layer (ETL);
a second semi-transparent or transparent upper electrode;
an upper transparent anti-permeant barrier;
a protective transparent polymeric layer.

4. OLED device according to any one of Claims 1) to 3), **characterised in that** the light emitted by the single emitting layer has a wavelength of between 425 nm and 525 nm, the luminescent fabric is capable of emitting orange, red or orange/red light, the down-converted light has a wavelength of between 630 nm and 770 nm and the overlapped light appears white.

5. OLED device according to any one of the preceding claims, **characterised in that** the first and second anti-permeant layers seal the entire OLED device, and wherein the edges of said anti-permeant layers are sealed by hot-melting of the edges or by lamination, using suitable resins.

6. Device according to any one of Claims 1) to 5), **characterised in that** the first and second anti-permeant layers seal the entire OLED device, and wherein the anti-permeant layers are produced by the deposition of a multilayer directly on the surface of the planarising layer or of the flexible substrate (bottom encapsulant), and on the device surface (top encapsulant), by means of thin film encapsulation (TFE) techniques.

7. OLED device according to any one of the preceding claims, **characterised in that** the two semi-transparent or transparent electrodes are two different electrodes, wherein one of the two electrodes is a Titanium-Indium-Oxide (ITO) based film, while the other electrode is a PEDOT:DSS multilayer.

8. Active signalling system, formed by an OLED component, cooperating with a technical fabric through a planarising layer, **characterised in that** the OLED component is a device according to any one of the preceding claims.

9. Active signalling system according to Claim 8), **characterised in that** the cooperation is maintained by installing said OLED device on the luminescent technical fabric, the installation being chosen from gluing and buttons.

10. Active signalling system according to Claim 8), **characterised in that** the cooperation is maintained by integrating said OLED device and the planarising layer on the luminescent technical fabric, the integration being achieved by use of a fabric printing machine.
